# EUROPEAN PATENT SPECIFICATION

(11) **EP 3 680 211 B1**
(45) Date of publication and mention of the grant of the patent: **06.03.2024**
(21) Application number: 19151102.1
(22) Date of filing: 10.01.2019
(51) Int. Cl.: B81B 7/00, B81C 1/00

(54) **SENSOR UNIT AND METHOD OF INTERCONNECTING A SUBSTRATE AND A CARRIER**
SENSOREINHEIT UND VERFAHREN ZUM VERBINDEN EINES SUBSTRATS UND EINES TRÄGERS
UNITÉ DE CAPTEUR ET PROCÉDÉ D'INTERCONNEXION D'UN SUBSTRAT ET D'UN SUPPORT

(43) Date of publication of application: 15.07.2020
(73) Proprietor: TE Connectivity Solutions GmbH, 8200 Schaffhausen (CH)
(72) Inventor: BRUNNER, Ismael, 2022 Bevaix NE (CH); ARNOLD, Thomas, 2027 Montalchez NE (CH); DRLJACA, Predrag, 2000 Neuchâtel NE (CH)
(74) Representative: Grünecker Patent- und Rechtsanwälte PartG mbB

(56) References cited:
- US-A1- 2005 082 653
- US-A1- 2015 060 954

## Description

The present invention relates to a sensor unit having at least one transducer element for monitoring at least one measurand and for generating an electrical output signal correlated with the at least one measurand. The present invention further relates to a corresponding method of interconnecting a substrate and a carrier, and specifically of assembling such a sensor arrangement.

In particular for automotive applications, a plurality of measurands is to be monitored, physical ones such as pressure or temperature as well as electrochemical ones such as gas concentrations (e. g. CO₂). In any case, the medium which is to be monitored has to gain access to defined sensitive elements of the sensor arrangement while it has to be ensured on the other hand that the aggressive and humid environment does not damage and/or impair the remaining parts, in particular the electronic components of the sensor arrangement. Moreover, the sensor unit has to be fabricated in high volume mass production, requiring an efficient assembly procedure.

Conventionally, sensor units comprise at least one transducer element for monitoring at least one measurand and generating an electrical output signal correlated with the at least one measurand, the one or more transducer element(s) being arranged on a first surface of a sensor substrate. This sensor substrate usually is rather thin and is also referred to as a membrane, mostly a ceramic membrane. This membrane has to be attached to a (usually thicker) circuit carrier. Electrical connections have to be established between the transducer element(s) and contact pads arranged on the circuit carrier. Additionally, the solder joint can also connect any other kind of electric or electronic element (e. g. one or more sensors, trimming resistors, or the like) located on top of the substrate (or second surface). The electrical connection is done by metallization of the walls of the opening or recess.

Document US-2015/060954 A1 discloses a sensor made up of two substrates which are adhered together. A first substrate includes a pressure-sensitive micro-electrical-mechanical (MEMS) structure and a conductive contact structure that protrudes outwardly beyond a first face of the first substrate. A second substrate includes a complementary metal oxide semiconductor (CMOS) device and a receiving structure made up of sidewalls that meet a conductive surface which is recessed from a first face of the second substrate. A conductive bonding material physically adheres the conductive contact structure to the conductive surface and electrically couples the MEMS structure to the CMOS device.

Document US-2005/082653 A1 discloses a method of making a plurality of sealed assemblies which includes a) assembling a first element to a second element so that a bottom surface of the first element faces downwardly toward a front surface of the second element and a top surface of the first element faces upwardly away from the second element and, (b) forming ring seals surrounding regions of the front surface of the second element by introducing flowable material between the first element and the second element from the top surface of the first element through openings in the first element.

This is usually a complicated fabrication process, or involves the risk of damaging the sensor substrate by mechanical stress.

The object underlying the present invention is to provide a sensor unit and a corresponding assembly method improving performance and reliability of the sensor arrangement and facilitating the manufacturing process, thereby overcoming, or at least substantially reducing the above mentioned problems and drawbacks.

This object is solved by the subject matter of the independent claims. Advantageous embodiments of the present invention are the subject matter of the dependent claims. Examples mentioned in the description that do not necessarily fall under the scope of the independent claims are constructed as examples useful for understanding the invention.

An example is based on the idea of providing openings in the sensor substrate through which an electrically conductive material, e. g. a solderable material, a conductive glue, or another conductive plastic material, such as silver filled epoxy resin, can be applied after the sensor substrate has been mounted on the circuit carrier. Thus, the process of applying the electrically conductive material can be performed from the backside of the sensor substrate and with the circuit carrier as a mechanical support. In this manner, the sensor substrate and specially the transducer elements are protected and the fabrication process is facilitated. In order to mechanically connect the sensor substrate and the circuit carrier, an electrically conductive glue can be added to the design. If the gap filling is effected by capillary effects, and the openings are formed by metallized vias, this electrically conductive glue is not mandatory.

In particular, a sensor unit according to the example comprises at least one transducer element for monitoring at least one measurand and generating an electrical output signal correlated with the at least one measurand, and a sensor substrate with a first surface and an opposing second surface, said sensor substrate comprising said transducer element and at least one first electrically conductive contact pad arranged on the first surface of the sensor substrate, wherein said first electrically conductive contact pad is electrically connected to the transducer element.

A recess is provided in the sensor substrate, the recess leading from the first surface to the second surface. The sensor substrate is mounted on a circuit carrier in a way that the first surface faces the circuit carrier. The sensor substrate may be mounted on the circuit carrier in a way that a media channel penetrating the circuit carrier allows access of the at least one measurand to the transducer element. Alternatively, access of the measurand may also be provided on the second surface of the sensor substrate.

According to the example, the circuit carrier comprises at least one second electrically conductive pad, wherein the first electrically conductive contact pad and the second electrically conductive contact pad are interconnected by an electrically conductive material that is filled in from the second surface towards the first surface of the sensor substrate, in other words, from the top surface which is facing upwards in order to make a printing process possible.

In the context of the example, the term "circuit carrier" is intended to encompass any sort of substrate having electrically conductive leads on which a sensor substrate (and optionally further electronic components) can be mounted. In particular, the circuit carrier may comprise a printed circuit board (PCB), a flexible circuit carrier (also called flexible printed circuit, FPC), a flex-rigid carrier (which is a combination of an FPC or a flat flexible cable with rigid elements), a ceramic substrate (thick film, LTCC, HTCC), glass, or the like. Moreover, the term "substrate" (or "sensor substrate") may also cover a PCB, an FPC, a flex-rigid carrier, a ceramic substrate (thick film, LTCC, HTCC), glass, or the like.

According to an advantageous example, said electrically conductive material is a solder material, for example a reflow solder material. Reflow soldering is a well-established technology of integrated circuit assembly and packaging. Generally, this technique is based on applying a solder paste on a substrate, for instance by screen printing, dispensing, jetting, or the like. A component to be soldered to the circuit carrier is placed with its electrically conductive leads being in direct contact with the solder paste. The solder paste is heated until it reaches the *liquidus* state (being reflowed) and then cooled until the solder hardens and creates a permanent interconnection between the component's electrically conductive leads and the circuit carrier. According to the example, the sensor substrate as well as the circuit carrier have leads and soldering pads which are for instance fabricated from silver or a silver alloy. Any other electrically conductive material may of course also be used. The electrically conductive material, such as a reflow solder paste, is screen printed or dispensed through the recess provided in the sensor substrate from a back side of the sensor substrate towards the circuit carrier. After heating the sensor unit to a temperature where the solderable material liquefies, an electrically conductive solder connection is established between the contact pads on the sensor substrate and the corresponding contact pads on the circuit carrier.

Advantageously, said recess is a preferably metallized tube-shaped via with a closed cross-section. For instance, the recess may have a circular cross-section. However, it is clear for a person skilled in the art that any other cross-section, for instance a polygonal cross-section may of course also be used.

Alternatively, the recess may also be arranged in a peripheral region of the sensor substrate and have an open cross-section. This open cross-section may for instance have the shape of a segment of a circle. Any other shape is of course also possible. The advantage of this solution can be seen in the fact that the recess can be fabricated on a panel level as a tube shaped hole arranged at one or more cutting lines where the sensor substrates are separated from each other.

In particular, metallized vias can be provided that are connected to electrically conductive leads of different circuits arranged on different sensor units. By cutting the panel and separating the sensor units, the vias are cut, so that each sensor unit has only a part of the sliced via arranged at the periphery of the sensor unit. It is clear for a person skilled in the art that such a technique of using shared and finally dissected vias can also be used with other electronic units, not only sensor units.

According to an advantageous example, the circuit carrier comprises at least one connecting pad which is interconnected to said second contact pad for connecting the sensor unit to an external component. For instance, the connecting pad may be formed by a surface mount technology (SMT) terminal which is interconnected to said second contact pad. The electrical connection between the SMT terminal and the circuit carrier advantageously can be established simultaneously with performing the reflow soldering step. SMT components combined with a reflow soldering technology are particularly easy to be used for the idea according to the example.

Advantageously, said transducer element is at least partly encompassed by a protective material that is attached to the first surface of the sensor substrate. This protective material may for instance comprise a sealing glass layer.

According to a further advantageous example, the transducer element comprises a microelectromechanical system (MEMS) gas sensor and/or a MEMS pressure sensor, in particular for automotive applications. Any other sensor arrangements with transducers requiring direct contact with the media to be monitored may of course also profit from the contacting technique according to the example.

According to an advantageous example, the sensor substrate comprises a ceramic chip carrier, for instance provided with at least one piezo resistive gauge.

An example further relates to a method of interconnecting a substrate and a carrier, preferably when assembling a sensor unit, said method comprising the following steps:
providing a substrate (preferably a sensor substrate with at least one transducer element, which is operable to monitor at least one measurand and to generate an electrical output signal correlated with the at least one measurand), wherein the substrate has a first surface and an opposing second surface, said substrate comprising at least one first electrically conductive contact pad arranged on the first surface of the substrate (preferably, said first electrically conductive contact pad is electrically connected to the transducer element), and wherein a recess is provided in the sensor substrate, the recess leading from the first surface to the second surface;
providing a circuit carrier for mounting said substrate;
mounting the substrate on the circuit carrier so that the first surface of the sensor substrate faces the circuit carrier;
through said recess, filling in an electrically conductive material from the second surface towards the first surface of the substrate;
performing a curing step so that an electrical connection, for instance a solder connection, is formed between the at least one first electrically conductive contact pad and the corresponding at least one second electrically conductive pad.

For instance, a solder material may be filled in by means of screen printing or dispensing a solder paste. Of course, also a jetting technique using a jet valve may be used.

The circuit carrier may have a media channel penetrating the circuit carrier so that it allows access of the at least one measurand to the transducer element.

For finally interconnecting the (sensor) substrate and the circuit carrier, the curing step comprises the step of heating the sensor unit, so that the electrically conductive material is liquefied.

As mentioned above, said recess is formed as a tube-shaped via with a closed cross-section, and/or said recess is arranged in a peripheral region of the sensor substrate and has an open cross-section.

Advantageously, the steps of mounting and soldering the sensor substrate onto the circuit carrier are performed as panel processes, with a plurality of units, preferably sensor units, being associated to each other, the method further comprising the step of separating the sensor units. As this is generally true for panel (or wafer) and batch processes, the fabrication of the sensor units is therefore more reliable and reproducible. At the same time the turnover of the production is much faster, so that the costs for the individual sensor units can be reduced.

In particular, the recesses may be formed as tube shaped metallized vias at regions which form corners and/or edges of the (sensor) unit, wherein by separating the units, recesses with open cross-sections are formed at the corners and/or the edges of the separated sensor units. In other words, each via is shared between adjacent units. This is done to minimize raw material cost, because the tube shaped vias are highly influencing the overall material expenditure. When providing metallized vias in the peripheral region, during production, two or more sensor units share one via. The shared via is later sliced into half tubes or quarter tubes (or any other suitable cross-sectional shape) forming the recess with an open cross-section when the individual sensor units are separated. The shape of the separated via parts of course depends on the number and angle of the cutting lines that intersect at the via.

In order to protect the transducer element from aggressive media, the method may further comprise the step of attaching a protective material so that it encompasses the transducer element at least partly. For instance, a glass layer or a plastic casting compound may be used as protective material.

According to certain examples, said sensor substrate comprises a ceramic chip carrier. However, it is clear for a person skilled in the art that any other type of substrate, for instance a PCB, a flexible circuit board, a leadframe, or the like may also be used according to the example.

The accompanying drawings are incorporated into the specification and form a part of the specification to illustrate several examples. These drawings, together with the description serve to explain the principles of the invention. The drawings are merely for the purpose of illustrating the preferred and alternative examples of how the invention can be made and used, and are not to be construed as limiting the invention to only the illustrated and described examples. Furthermore, several aspects of the examples may form-individually or in different combinations-solutions according to examples. The following described examples thus can be considered either alone or in an arbitrary combination thereof. Further features and advantages will become apparent from the following more particular description of the various examples, as illustrated in the accompanying drawings, in which like references refer to like elements, and wherein:
- **FIG. 1**: is a schematic perspective view of a sensor unit according to a first example;
- **FIG. 2**: is a schematic sectional view of the sensor arrangement according to Fig. 1, wherein Fig. 2A shows the sensor unit before solder reflow, while Fig. 2B shows the sensor unit after solder reflow;
- **FIG. 3**: shows a detail of Fig. 1;
- **FIG. 4**: shows another detail of Fig. 1;
- **FIG. 5**: is a schematic perspective view of a sensor unit according to a further example;
- **FIG. 6**: is a schematic sectional view of the sensor arrangement according to Fig. 5, wherein Fig. 6A shows the sensor unit before solder reflow, while Fig. 6B shows the sensor unit after solder reflow;
- **FIG. 7**: shows a detail of Fig. 5;
- **FIG. 8**: shows another detail of Fig. 5;
- **FIG. 9**: shows another detail of Fig. 5 in a top view;
- **FIG. 10**: shows another detail of Fig. 5 in a side view;
- **FIG. 11**: is a schematic perspective view of a sensor unit according to a further example;
- **FIG. 12**: is another perspective view of the sensor unit shown in Fig. 11;
- **FIG. 13**: shows an upper side of panel layout pattern according to an advantageous example;
- **FIG. 14**: shows an underside of a panel layout pattern according to an advantageous example;
- **FIG. 15**: shows a detail of a screen printing mesh pattern according to an advantageous example;
- **FIG. 16**: is a schematic representation illustrating a fabrication process according to an example;
- **FIG. 17**: schematically shows an upper side of a panel layout pattern illustrating various advantageous examples of shared vias;
- **FIG. 18**: schematically shows an upper side of a circuit carrier layout pattern according to a further advantageous example;
- **FIG. 19**: shows a detail of Fig. 19;
- **FIG. 20**: is a perspective view of a part of the panel of Figures 18 and 19 after electric/electronic components have been assembled and with the sensor substrates attached to the circuit carriers;
- **FIG. 21**: is a perspective transparent view of the arrangement shown in Fig. 20.

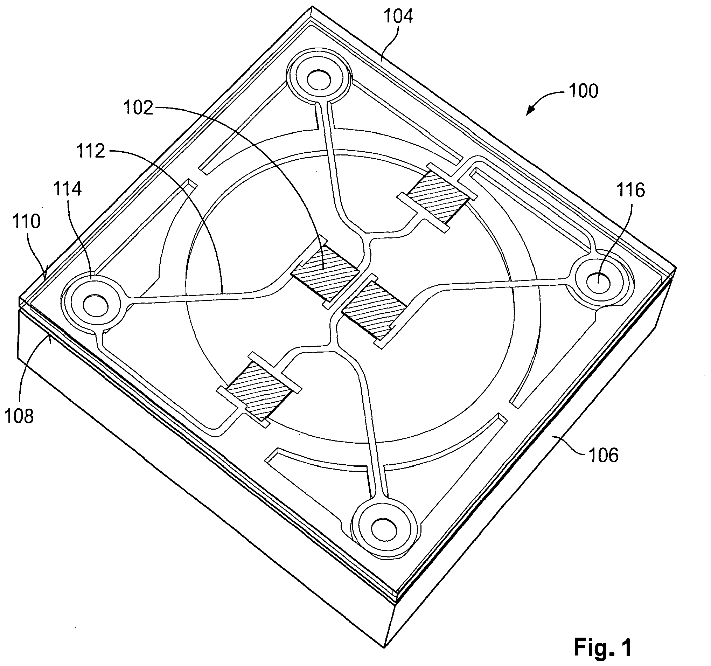

An example will now be further explained referring to the Figures, and firstly referring to Figure 1. Fig. 1 schematically illustrates in a schematic perspective view a sensor unit 100 according to a first example.

The sensor unit 100 comprises a sensor substrate 104 mounted on a circuit carrier 106, which is for instance fabricated from alumina. The sensor substrate 104 has a first surface 108 which is on the under side shown in Fig. 1 and faces the circuit carrier 106, and a second surface 110 which is on the upper side as shown in Fig. 1. It has to be noted that the sensor substrate 104 is depicted as being transparent in Fig. 1.

According to the example, the sensor unit 100 is a pressure sensor and comprises four piezo resistive strain gauges which form transducer elements 102. The sensor substrate 104 forms a displaceable membrane. The transducer elements 102 are arranged on the first surface 108 of the sensor substrate 104 which forms a displaceable membrane. The circuit carrier 106 may have an opening penetrating the circuit carrier 106 and thus forming a media access channel below the transducer elements 102 (not shown in the Figures). Alternatively, the media access is effected from the upper side 110 with an additional housing (not shown).

The strain gauge detects the displacement of the membrane due to a pressure difference between the two surfaces of the membrane.

The transducing elements 102 are connected to electrically conductive leads 112 which are for instance formed from silver or a silver alloy. The leads 112 are connected to electrically conductive first contact pads 114.

At each contact pad 114, the sensor unit 100 has circular a recess 116, which penetrates the sensor substrate 104 from the second surface 110 to the first surface 108. The diameters of the recesses 116 are large enough to allow solder material to be filled in by screen printing or other dispensing techniques and reach corresponding second electrically conductive contact pads 118 which are arranged on the circuit carrier 106 (not visible in Fig. 1). By means of a reflow soldering, a firm electrical connection can be established between the first and the second electrically conductive contact pads 114, 118. Advantageously, screen printing (or otherwise dispensing) the solder paste can be performed after the membrane-substrate assembly. This further provides the advantage of processing at panel level which is interesting cost saver.

In particular, a solderable precursor is for instance screen printed into the recesses 116 after the sensor substrate 104 has been aligned on the circuit carrier 106, so that the solderable contact pads 114, 118 of the sensor substrate and of the circuit carrier 106 are aligned with each other. Next, the sensor unit 100 is heated up until the precursor material reaches the *liquidus* state. After cooling down, the solder connections are established, forming the electrical connections between the circuit carrier 106 and the sensor substrate 104.

It is clear for a person skilled in the art that also conductive glues or any other electrically conductive material that has a temporary fluid state, such as a silver filled epoxy, may also be used according to the example.

In the example shown in Fig. 1, the contact pads and the recesses 116 are distanced apart from the edges of the sensor unit 100 and are formed by tube-shaped openings which have a closed circular diameter. Of course, the outline of the recesses 116 does not necessarily have to be circular, but may also be rectangular or have any other suitable shape.

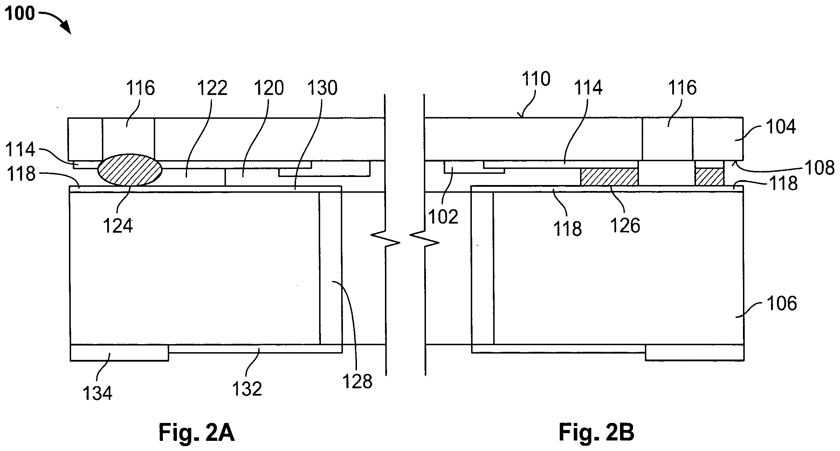

Fig. 2 shows a schematic cross sectional view of the arrangement according to Fig. 1. Fig. 2A shows the state of the sensor unit 100 after the solderable material has been applied, but has not yet been heated. Fig. 2B shows the final state of the sensor unit 100 after the reflow heating step has been performed.

As can be seen from Fig. 2A and 2B, the piezo resistive gauges 102 are covered by a protective glass layer 120. The protective glass layer 120 causes a narrow gap 122 to be formed between the first contact pads 114 and the second electrically conductive contact pads 118.

According to the example, the solder paste 124 is filled into the recess 116 in a direction from the second surface 110 towards the first surface 108 and reaches the second electrically conductive contact pads 118. When applying heat to the sensor unit 100, the solder paste 124 liquefies and is drawn by capillary forces into the gap 122, thereby forming a solder connection 126 between the first and the second electrically conductive contact pads 114, 118.

The circuit carrier 106 further comprises metallized vias 128 which connect second electrically connected leads 130 arranged on the upper surface of the circuit carrier 106 to electrically conductive leads 132 connected with terminal 134. According to the example shown in Fig. 2A and 2B, the via 128 is located at some distance apart from the first and second electrically conductive contact pads 114, 118.

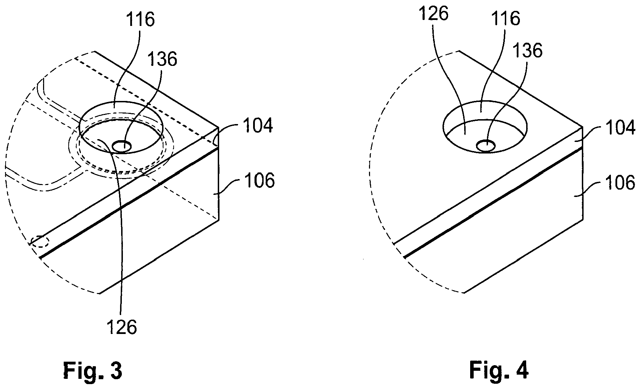

Figures 3 and 4 illustrate the region of the recesses 116 as a detail, wherein Fig. 3 shows the sensor substrate 104 and the circuit carrier 106 transparent. As can be seen from this representation, the solder connection 126 does not cover the complete contact pad 118, but leaves an uncovered region 136. In other words, the solder connection 126 forms a ringshaped electrically conductive connection between the first and second electrically conductive contact pads 114, 118. The reason for this particular shape is the fact that during the heating step the liquefied solder is drawn by capillary forces into the gap 122 between the sensor substrate 104 and the circuit carrier 106.

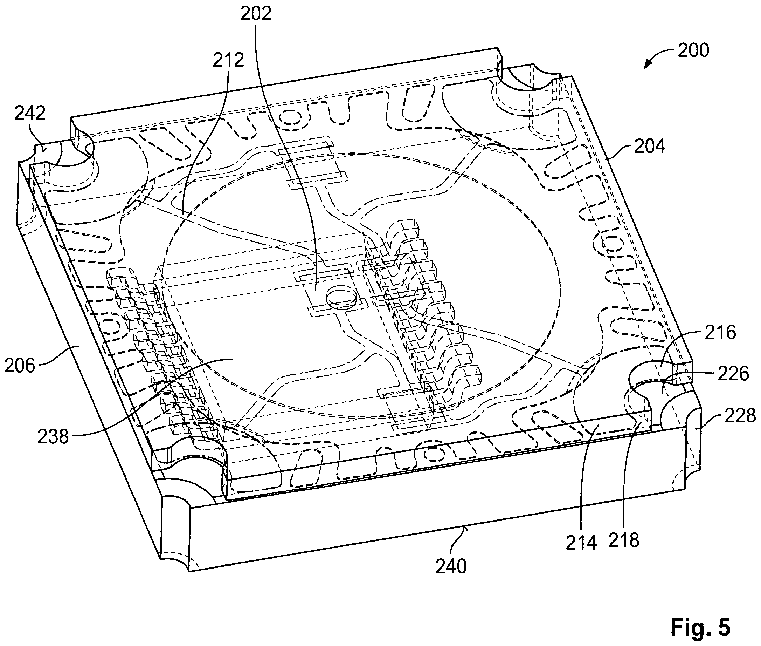

Another advantageous example will now be explained with reference to Fig. 5. The sensor unit 200 according to the second example differs from the sensor unit 100 explained above mainly in the location of the solder connections 226 and of the vias 228. The sensor unit 200 comprises a sensor substrate 204 which is attached to a circuit carrier 206. According to the second example, for recesses 216 are arranged at the corner of the sensor unit 200. It is clear for a person skilled in the art, that also a non-symmetrical arrangement of the recesses 216, or an arrangement not at the corner but at the edge of the sensor unit 200 is possible according to the example.

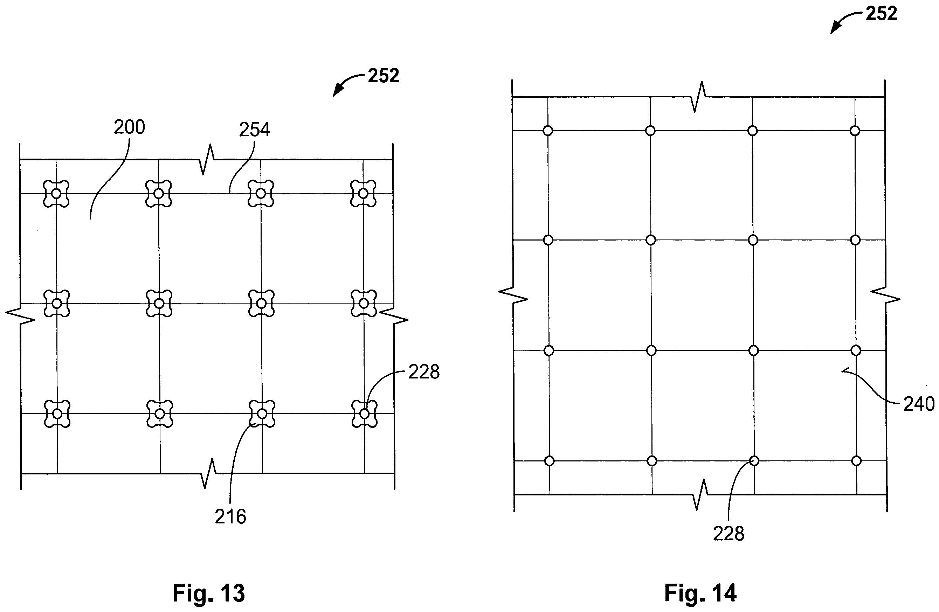

As shown in Fig. 5, the recesses 216 and the solder connection 226 are located close to the metallized vias 228. This layout has several advantages. Firstly, by arranging the first electrically conductive contact pads 214 in close vicinity to the via 228, no additional leads from the second electrically conductive pads 218 to the vias 228 are needed. This saves space on the circuit carrier 206. Furthermore, when fabricating the sensor unit 200 on a panel level, comparatively large openings can be provided as the recesses 216, thus facilitating filling in the solderable material from the membrane side. The location of the solder connections 226 close to the peripheral region, in particular at the corners of the sensor unit 200 is achieved by separating the individual sensor units 200. The process will become more apparent below with reference to Figures 13 to 15.

Referring to Fig. 5, the sensor unit 200 further comprises four transducer elements 202 which are connected by means of electrically conductive leads 212 to the first electrically conductive contact pads 214. Furthermore, an electronic sensing and control circuit 238 is provided at an underside of the circuit carrier 214. The underside 240 is opposed to the surface 242 which faces the substrate 204.

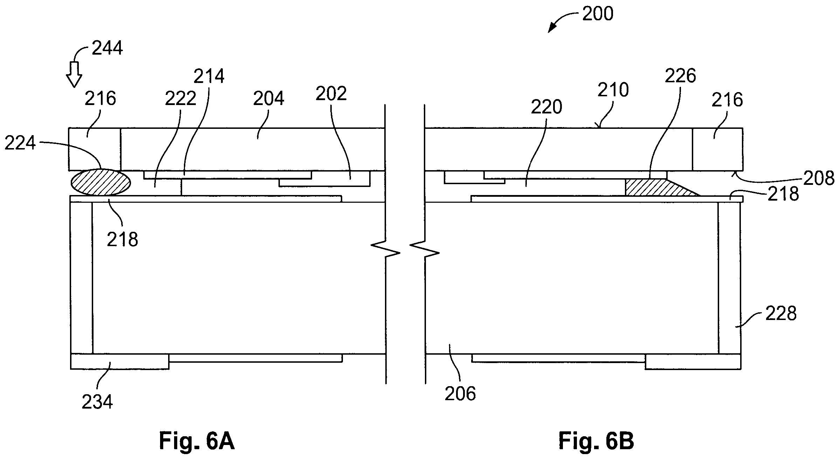

Figures 6A and 6B show the sensor unit 200 of Fig. 5 in a sectional view. In particular, Fig. 6A shows the sensor unit after the solderable material 224 has been dispensed or screen-printed from the first surface 210 of the substrate 204. Fig. 6B shows the sensor unit after solder reflow, where the solder connection 126 is formed and the sensor substrate 204 is firmly bonded to the circuit carrier 206.

As schematically shown in Fig. 6A, the solderable material 224 is filled in from the surface 210 of the circuit substrate 204 onto the second electrically conductive contact pads 218 as indicated by the arrow 244. According to the example, a gap 222 is left between the first and second electrically conductive contact pads 214, 218. Consequently, when the sensor unit 200 is heated after the solderable material 224 has been filled in, capillary forces draw the liquefied solderable material towards the protective glass layer 220, forming an electrically conductive bond between the first and the second electrically conductive contact pads 214, 218.

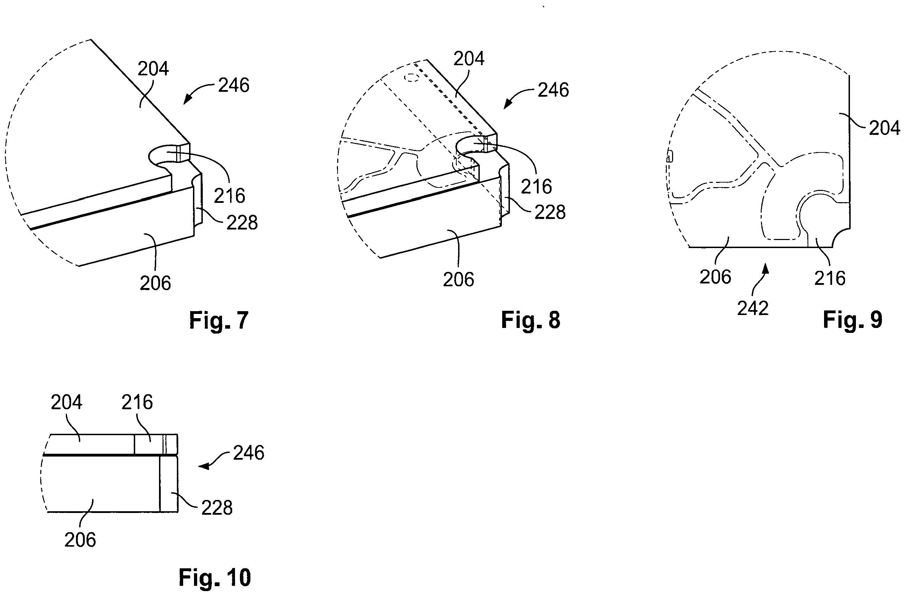

Fig. 7 to 10 illustrate several detailed views of a corner region 246 of the sensor unit 200 shown in Figures 5 and 6.

As already mentioned, according to an aspect of the example, the recess 216 is located in close vicinity to the via 228. Thereby, the problem arises, that when filling in the solderable material 224, it could be filled into the via 228. In this case, the capillary forces might not be able to draw the liquefied solderable material between the first and the second electrically conductive contact pads 214, 218.

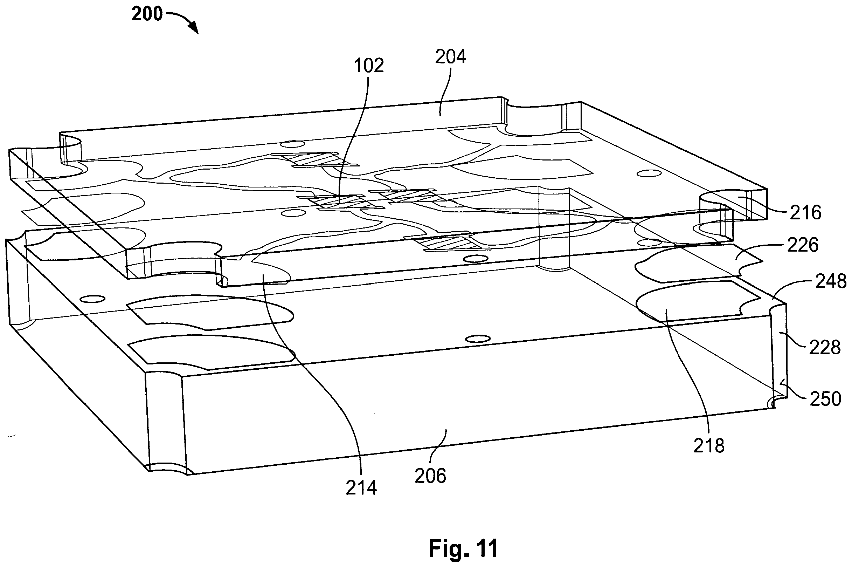

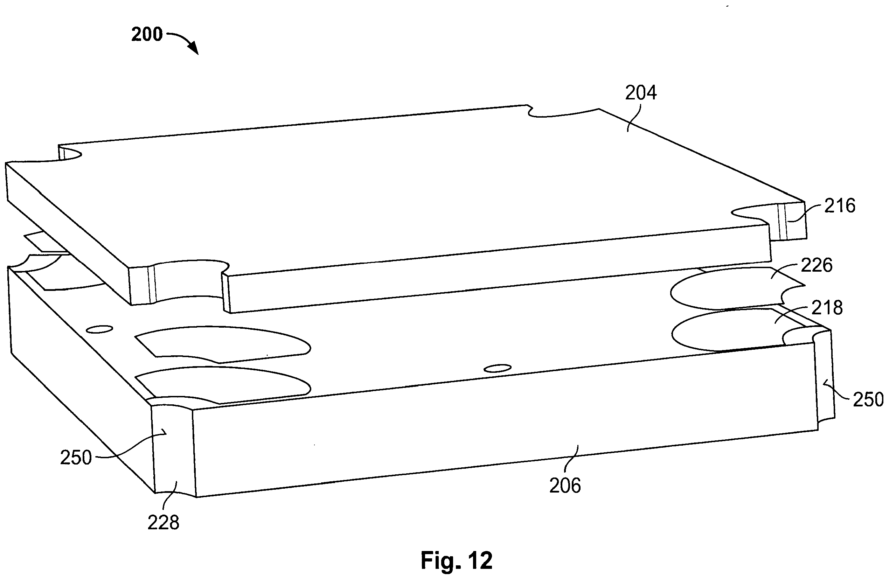

A possibility to overcome this drawback can be seen from Figures 11 and 12. According to this example, solder free areas 248 are provided directly adjacent to the via 228. Advantageously, these solder free areas 248 are part of a dielectric coating 250 which covers the via 228.

Figures 13 and 14 illustrate the fabrication process of the sensor unit 200 according to the example on a panel level.

In Fig. 13, a top view of the panel 252 with the attached sensor substrate is shown. As can be seen from this Figure, a plurality of not yet individualized sensor units 200 are arranged side by side. The later corner regions 246 are located at the intersections of the die cutting lines 254. By the later cutting process, each sensor unit 200 has a via 228 with the quarter-circle shaped cross-section. As already mentioned above, the via may also lie along the die cutting lines 254, leaving each sensor unit 200 with a via 228 having a semi circular cross-section. Moreover, the number of connections is determined by the particular application. However, the arrangement according to the second example as described above is particularly efficient and space saving. Fig. 14 shows the underside view of the panel, where only the holes of the vias 228 are visible.

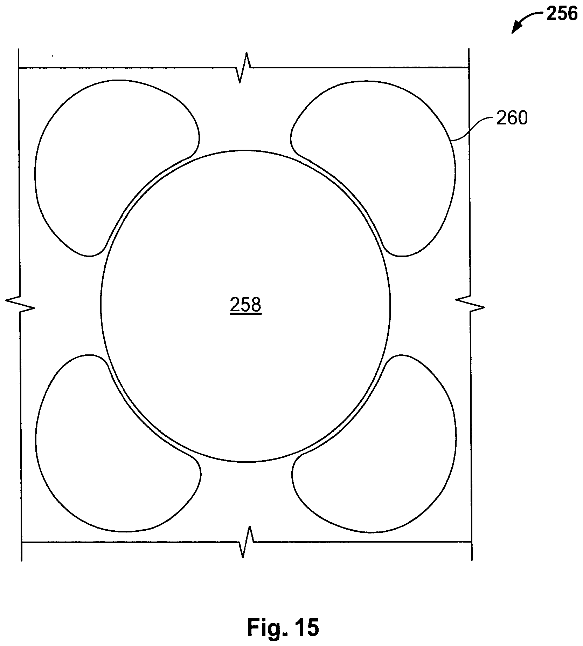

Fig. 15 shows a detail of the screen printing mesh 256 that can be used for screen printing solder of the material into the recesses 216 shown in Fig. 13. Corresponding to each of the openings 216 of Fig. 13, the screen printing mesh has a central region 258 which blocks the dispensing of solderable material into the via. Openings 260 which coincide with the corner regions 246 of the later individual sensor unit 200 are provided in the mesh 256 for dispensing solder paste into the recesses 216 shown in Fig. 13. Of course, the particular shape of the openings 260 may be varied according to the characteristics of the solder paste.

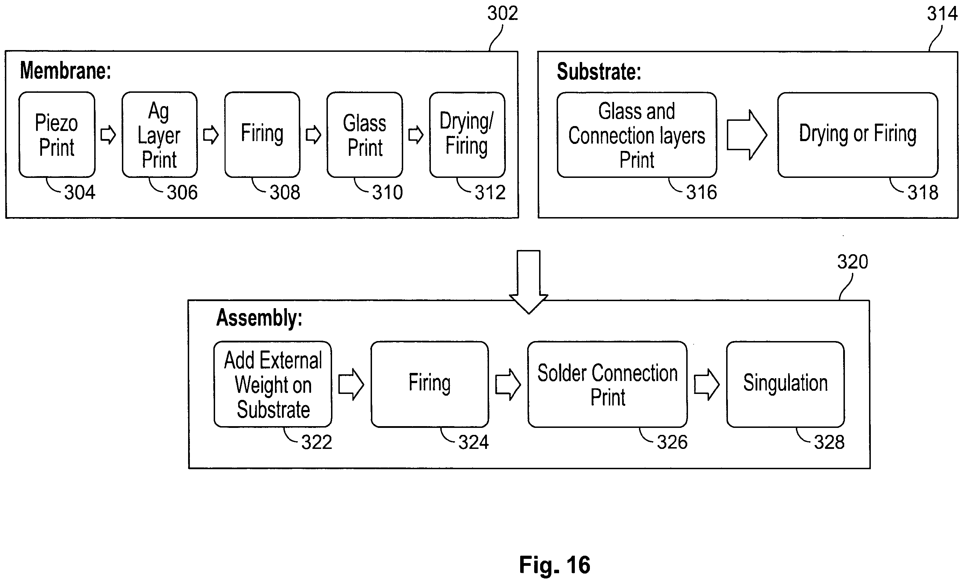

An exemplary method of fabricating a pressure sensor unit 200 will now be explained with reference to Fig. 16 together with Figures 5 to 15.

Block 302 describes the assembly of the sensor substrate 204. (As already mentioned above the sensor substrate may also be referred to as a "membrane".) First, the piezoelectric layers forming the transducer elements are printed onto a ceramic substrate. In step 306, a structured silver layer is printed which forms the electrically conductive leads and contact pads. In a next step 308, the membrane arrangement is fired in order to consolidate the piezoelectric layer and the conductive leads and pads. The protective glass layer 220 is added to the sensor substrate 204 in step 310. In a final drying and/or firing step 312 the sensor substrate 204 is finished.

Fabrication block 314 illustrates the fabrication of the circuit carrier 206, sometimes also referred to as a "substrate". In step 316 all necessary glass and connection layers are printed onto ceramic substrates. A drying and/or firing step 318 finalizes the circuit carrier. It is clear for a person skilled in the art that also additional electronic components, e. g. resistors or capacitors, can be integrated into the circuit carrier if needed.

Fabrication block 320 illustrates the assembly of the membrane and the substrate. On a panel level, the membrane and the substrate are aligned with each other and an additional weight is placed on the stack (step 322). In step 324, the stack is fired for effecting an adhesion between the glass layer 220 and the upper surface 242 of the circuit carrier.

Next, in step 326, the solder paste is screen printed into the openings 216 from the membrane side, and a reflow step may be performed for fixing the solder connection. In step 328, the individual sensor units are separated from each other by known chip singulation techniques, e. g. sawing, laser cutting, snapping etc.

Alternatively, the solder connections are not yet heated up in step 326, but the sensor units 200 are singulated with only the solder paste printed. In this case, the reflow step is performed together with reflow soldering the sensor unit to an external component (not shown in the Figures) or when attaching the electronic sensing and control circuit 238.

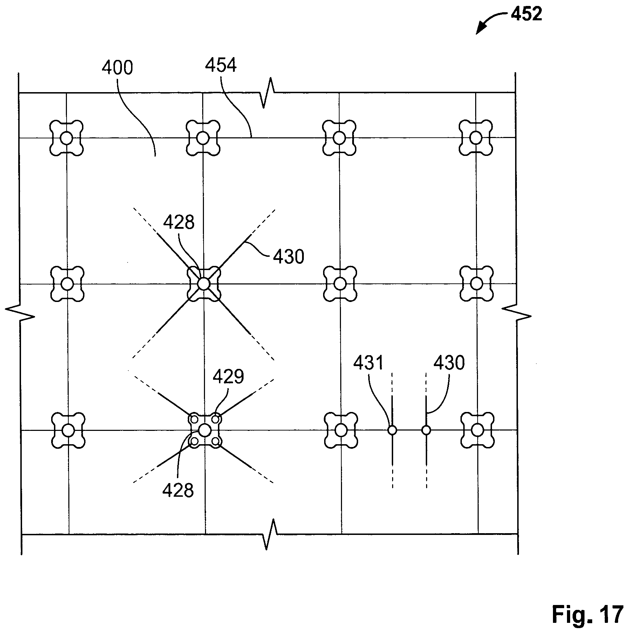

Fig. 17 illustrates in more detail the idea of using vias shared during the production until the individual units are separated. It has to be noted that this concept may be used with other electrical or electronic units as well, not only with sensor units.

In this Figure, a top view of a panel 452 with the attached sensor substrate is shown. As can be seen from this Figure, a plurality of not yet individualized electric or electronic units 400 (e. g. sensor units as described above) are arranged side by side. Several different geometries are schematically combined in this drawing. Of course, not all of these variants have to be realized on the same panel 452.

The later corner regions are for instance located at the intersections of the die cutting lines 454. By the later cutting process, each unit 400 may have a via 428 with the quarter-circle shaped cross-section connected to an electrically conductive lead 430 (only schematically represented). As shown in Figure 5, after the subdividing step, the metallized via 428 establishes the electrical contact between both sides of the circuit carrier.

Alternatively, additional vias 429 can be provided around the central via 428, so that after the cutting step each circuit has a separate additional recess with a closed (for instance circular) cross-section similar to the arrangement shown Fig. 1.

Furthermore, one or more castellation vias 431 may be arranged along one die cutting line 454, so that they are intersected by only one cutting line instead of being the crossing point of a plurality of cutting lines as shown for via 428. In this configuration, a castellation geometry along an edge of the unit's circuit carrier is generated after the cutting step.

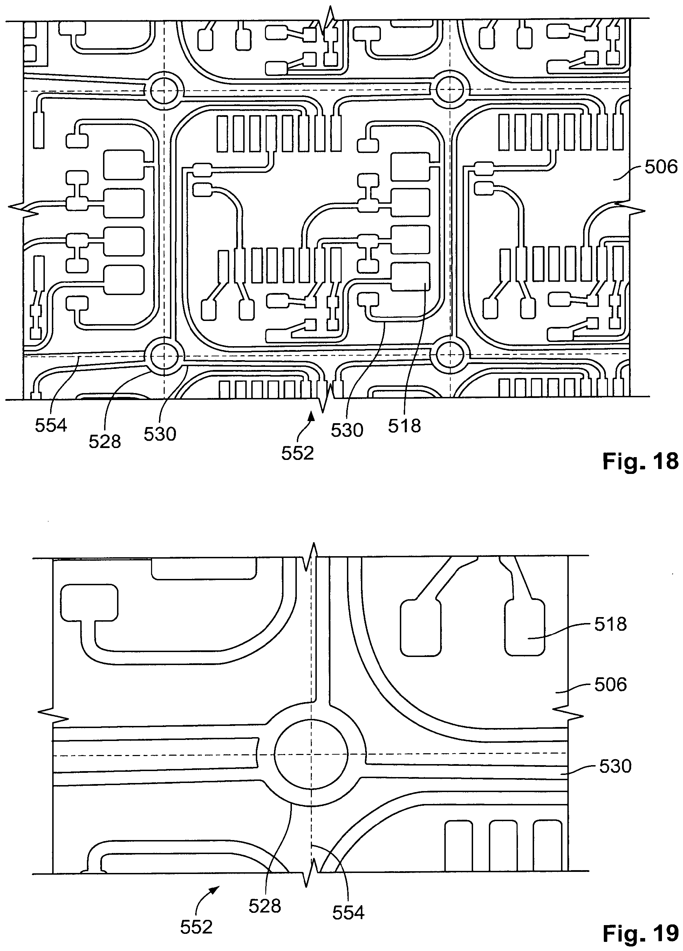

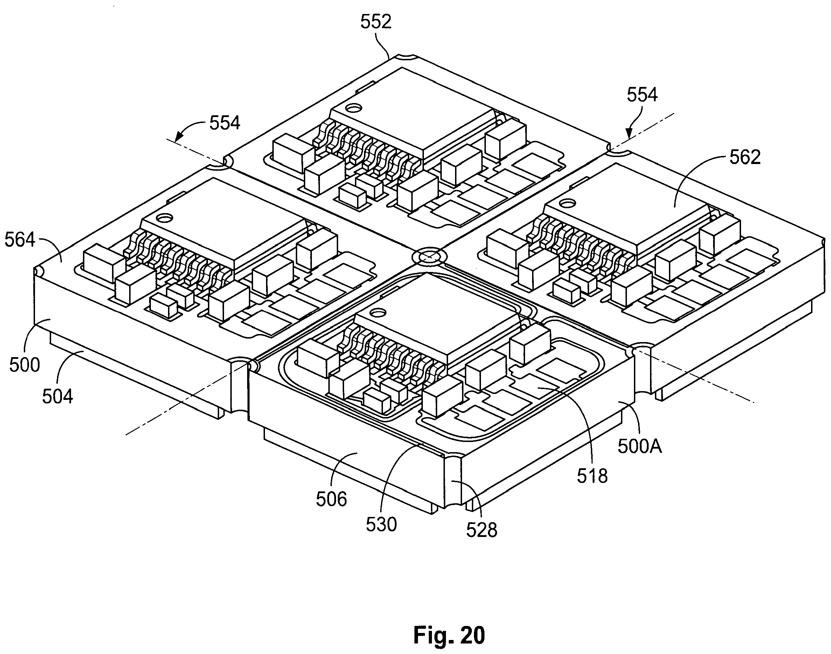

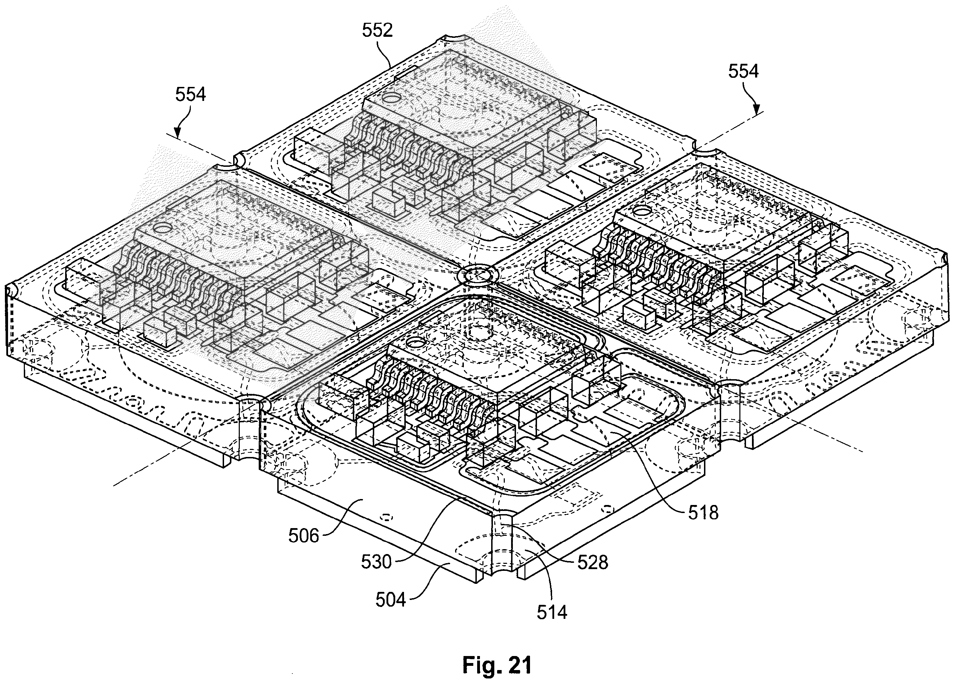

Fig. 18 illustrates the layout of a circuit carrier panel 552 according to a further advantageous example. On the panel 552, a plurality of circuit carriers 506 are fabricated side-by-side by providing a circuit carrier material with electrically conductive elements. For instance, various electrically conductive contact pads 518 are arranged on this upper surface of the circuit carrier 506 for electrically contacting the sensor substrate and for attaching electric and electronic components as will become apparent from Figures 20 and 21. Electrically conductive leads 530 are provided to interconnect the electric/electronic components to each other or to a via 528. By cutting the panel 552 along the grid of intersecting cutting lines 554, a plurality of separate units can be fabricated. Each of the units will then have a quarter of a via 528 at each of its corners.

According to the example, the separating of the individual units will only be performed after the sensor substrates have been assembled. Before the soldering step, the inner electrically conductive surface of the vias 528 may be coated with an electrically insulating layer to avoid the solder material to enter in the via. The via 528 establishes an electrical connection to the opposing surface of the circuit carrier 506.

Fig. 19 shows a detail of Fig. 18, wherein the via 528 and its surroundings are enlarged. As can be seen from this Figure, the layout of the panel 552 is designed in a way that after cutting along the cutting lines 554, each circuit carrier 506 has a quarter of the volume 528, connected to one electrically conductive lead 530. Advantageously, the electrically conductive leads which are connected to the metallization of the via 528, run in parallel to the cutting lines 554, so that they are not damaged by the cutting process. The idea is to share one single through hole for four circuits, each corner of one unit (still in the array in Figures 18 and 19) is taking a quarter of the metallized hole for the electrical connection from one side of the board to the other. After the soldering step and the separation step, a quarter of the metallized via 528 provides a full contact through the thickness of the circuit carrier at each corner of each finally assembled electronic unit.

On the back side of the panel 552, further contact pads (corresponding to reference numeral 218 in Fig. 11) are provided, which connect to the ceramic membrane with sensing elements (reference numeral 204 of Fig. 10 and reference numeral 504 of Fig. 20).

The panel 552 is for instance fabricated from a ceramic material, the electrically conductive elements, such as the contact pads 518 and the leads 530, being fabricated in thick-film technology.

However, the panel 552 could also be a printed circuit board (PCB) formed from glass-reinforced epoxy laminate material, for instance a so-called FR4 material, with electrically conductive copper leads and metallized via holes. Any other suitable technology for fabricating a circuit carrier may as well be used. Also flat flexible carriers can be used with the example.

Fig. 20 shows a part of the panel 552 of Figures 18 and 19 after electric/electronic components 562 have been assembled and with the sensor substrates 504 attached to the circuit carriers 506. According to the example, each via 528 is connected to four surrounding sensor substrates 504 by electrically conductive leads 530.

According to the example, various passive and active components as well as electronic circuits can be arranged on the upper surface of the circuit carrier 506. Advantageously, all the electronic circuitry is assembled on the panel 552 before separating the individual units 500 along the cutting lines 554. This facilitates the assembly process and reduces the costs.

Optionally, the electrically conductive leads 513 can be covered with a non-conductive protective layer 564. The protective layer 564 may leave open some of the electrically conductive pads 518, so that they remain accessible for instance for a wire bonding step or any other electrically connecting step. It has to be noted that in the representation of Figures 20 and 21 only four units 500 are shown to be still interconnected in order to illustrate how the vias 528 are divided by separating the units. Of course, this array of four units usually is part of a much larger panel 552. Furthermore, sensor unit 500A is represented without having a protective layer 564 covering the leads 413 for illustrative purposes.

Fig. 21 shows the arrangement of Fig. 20 in a transparent view so as to illustrate the sensor substrate 504 in more detail. in this depiction, it becomes apparent that the metallized via 528 is connected to the electrically conductive contact pad 514 arranged on the backside of carrier 506, for solder bonding the sensor substrate 504.

### REFERENCE NUMERALS

| **Reference Numeral** | **Description** |
|---|---|
| 100, 200, 500 | Sensor unit |
| 102, 202 | Transducer element |
| 104, 204, 504 | Sensor substrate |
| 106, 206, 506 | Circuit carrier |
| 108, 208 | First surface of sensor substrate |
| 110, 210 | Second surface of sensor substrate |
| 112, 212 | Electrically conductive lead on sensor substrate |
| 114, 214, 514 | First electrically conductive contact pad |
| 116, 216 | Recess |
| 118, 218, 518 | Second electrically conductive contact pad |
| 120, 220 | Protective glass layer |
| 122, 222 | Gap |
| 124, 224 | Solder paste |
| 126, 226 | Solder connection |
| 128, 228, 528 | Via |
| 130, 430, 530 | Electrically conductive lead on upper side of the circuit carrier |
| 132 | Electrically conductive lead on underside of the circuit carrier |
| 134 | Terminal |
| 136 | Uncovered region |
| 238 | Electronic sensing and control circuit |
| 240 | Underside of circuit carrier |
| 242 | Upper surface of circuit carrier |
| 244 | Direction of filling in solderable material |
| 246 | Corner region |
| 248 | Solder free area |
| 250 | Dielectric coating |
| 252, 552 | Panel |
| 254, 454, 554 | Cutting lines |
| 256 | Screen printing mesh |
| 258 | Central region |
| 260 | Openings in the screen printing mesh |
| 302-328 | Fabrication method steps |
| 452, 552 | Panel |
| 400 | Electric or electronic unit |
| 428, 429, 431, 528 | Via |
| 562 | Electric/electronic component |
| 564 | Protective layer |

## Claims

1. Sensor unit comprising:
at least one transducer element (102, 202) for monitoring at least one measurand and generating an electrical output signal correlated with the at least one measurand;
a sensor substrate (104, 204) with a first surface (108, 208) and an opposing second surface (110, 210), said sensor substrate (104, 204) comprising said transducer element (102, 202) and at least one first electrically conductive contact pad (114, 214) arranged on the first surface (108, 208) of the sensor substrate (104, 204), wherein said first electrically conductive contact pad is electrically connected to the transducer element;
wherein a recess (116, 216) is provided in the sensor substrate (104, 204), the recess (116, 216) extending from the second surface (110, 210) to the first surface (108, 208), the recess being arranged to allow an electrically conductive material (124, 224, 126, 226) to be filled in
wherein said sensor substrate (104, 204) is mounted on a circuit carrier (106, 206) in a way that the first surface (108, 208) faces a surface of the circuit carrier (106, 206);
wherein the circuit carrier (106, 206) comprises at least one second electrically conductive pad (118, 218) arranged on the surface of the circuit carrier, wherein the first electrically conductive contact pad (114, 214) and the second electrically conductive contact pad (118, 218) are interconnected by the electrically conductive material (124, 224 126; 226);
wherein the at least one transducer element (102, 202) is at least partly encompassed by a protective material (120, 220), the protective material being arranged to form a gap (122, 222) between the first electrically conductive contact pad (114, 214) and the second electrically conductive contact pad (118, 218).

2. Sensor unit according to claim 1, wherein said electrically conductive material is a solder material (124, 224; 126; 226), an electrically conductive glue, or a metal filled epoxy resin.

3. Sensor unit according to claim 1 or 2, wherein said recess (116, 216) is a tube-shaped via with a closed cross-section.

4. Sensor unit according to claim 1 or 2, wherein said recess (116, 216) is arranged in a peripheral region of the sensor substrate and has an open cross-section.

5. Sensor unit according to one of the preceding claims, wherein the circuit carrier (106, 206) comprises at least one connecting pad (134, 234) which is interconnected to said second contact pad for connecting the sensor unit (100, 200) to an external component.

6. Sensor arrangement according to one of the preceding claims, wherein said transducer element (102, 202) comprises a microelectromechanical system (MEMS) gas sensor and/or a MEMS pressure sensor.

7. Sensor unit according to one of the preceding claims, wherein said sensor substrate (104, 204) and/or the circuit carrier (106, 206) comprises a ceramic chip carrier.

8. Method of interconnecting a substrate and a carrier, said method comprising the following steps:
providing at least one transducer element (102, 202) for monitoring at least one measurand and generating an electrical output signal correlated with the at least one measurand;
providing a substrate (104, 204), wherein the substrate (104, 204) has a first surface (108, 208) and an opposing second surface (110, 210), said substrate comprising said transducer element (102, 202) and at least one first electrically conductive contact pad (114, 214) arranged on the first surface (108, 208) of the substrate, wherein a recess (116, 216) is provided in the substrate, the recess extending from the first surface to the second surface;
providing a circuit carrier (106, 206) for mounting said substrate (104, 204), the circuit carrier (106, 206) having at least one second electrically conductive pad (118, 218) to be connected to the first electrically conductive contact pad (114, 214), the second electrically conductive pad being arranged on a surface of the circuit carrier (106, 206) configured to face the first surface (108, 208) of the substrate;
mounting the substrate (104, 204) on the circuit carrier so that the first surface of the substrate faces the surface of the circuit carrier;
through said recess (116, 216), filling in an electrically conductive material from the second surface towards the first surface of the substrate;
performing a curing step of the electrically conductive material so that an electrical connection is formed between the at least one first electrically conductive contact pad and the corresponding at least one second electrically conductive pad;
wherein the at least one transducer element (102, 202) is at least partly encompassed by a protective material (120, 220),
the protective material (120, 220) is arranged to form a gap (122, 222) between the first electrically conductive contact pad (114, 214) and the second electrically conductive contact pad (118, 218).

9. Method according to claim 8, wherein said electrically conductive material is filled in by means of screen printing or dispensing a solder paste and/or wherein said curing step comprises heating , so that the electrically conductive material is liquefied.

10. Method according to one of the claims 8 to 9, wherein said recess (116, 216) is formed as a metallized tube-shaped via with a closed cross-section, and/or wherein said recess is arranged in a peripheral region of the sensor substrate and has an open cross-section.

11. Method according to one of the claims 8 to 10, wherein the steps of mounting and soldering the substrate onto the circuit carrier are performed as panel processes, with a plurality of units being associated to each other, the method further comprising the step of separating the units.

12. Method according to claim 11, wherein the recesses (116, 216) are formed as tube shaped vias at regions which form corners and/or edges of the units, and wherein by separating the units, recesses with open cross-sections are formed at the corners and/or edges of the separated units.

13. Method according to one of the claims 8 to 12, wherein the substrate is a sensor substrate (104, 204) with at least one transducer element (102, 202), which is operable to monitor at least one measurand and to generate an electrical output signal correlated with the at least one measurand.

14. Method according to claim 13, further comprising the step of attaching the protective material (120, 220) so that it encompasses the transducer element at least partly.

## Patentansprüche

1. Sensor-Einheit, die umfasst:
wenigstens ein Wandlerelement (102, 202) zum Überwachen wenigstens einer Messgröße sowie zum Erzeugen eines elektrischen Ausgangssignals, das mit der wenigstens einen Messgröße korreliert;
ein Sensor-Substrat (104, 204) mit einer ersten Fläche (108, 208) und einer gegenüberliegenden zweiten Fläche (110, 210), wobei das Sensor-Substrat (104, 204) das Wandlerelement (102, 202) sowie wenigstens eine erste elektrisch leitende Kontaktfläche (114, 214) umfasst, die an der ersten Fläche (108, 208) des Sensor-Substrats (104, 204) angeordnet ist, und die erste elektrisch leitende Kontaktfläche elektrisch mit dem Wandlerelement verbunden ist;
wobei eine Aussparung (116, 216) in dem Sensor-Substrat (104, 204) vorhanden ist, sich die Aussparung (116, 216) von der zweiten Fläche (110, 210) zu der ersten Fläche (108, 208) erstreckt und die Aussparung so eingerichtet ist, dass ein elektrisch leitendes Material (124, 224, 126, 226) eingefüllt werden kann,
das Sensor-Substrat (104, 204) an einem Schaltungsträger (106, 206) so angebracht ist, dass die erste Fläche (108, 208) einer Fläche des Schaltungsträgers (106, 206) zugewandt ist;
der Schaltungsträger (106, 206) wenigstens eine zweite elektrisch leitende Kontaktfläche (118, 218) umfasst, die an der Fläche des Schaltungsträgers angeordnet ist, die erste elektrisch leitende Kontaktfläche (114, 214) und die zweite elektrisch leitende Kontaktfläche (118, 218) über das elektrisch leitende Material (124, 224; 126; 226) miteinander verbunden sind;
und das wenigstens eine Wandlerelement (102, 202) wenigstens teilweise von einem schützenden Material (120, 220) umschlossen ist, das schützende Material so eingerichtet ist, dass es einen Spalt (122, 222) zwischen der ersten elektrisch leitenden Kontaktfläche (114, 214) und der zweiten elektrisch leitenden Kontaktfläche (118, 218) bildet.

2. Sensor-Einheit nach Anspruch 1, wobei das elektrisch leitende Material ein Lotmaterial (124, 224; 126; 226), ein elektrisch leitender Klebstoff oder ein metallgefülltes Epoxidharz ist.

3. Sensor-Einheit nach Anspruch 1 oder 2, wobei die Aussparung (116, 216) ein röhrenförmiges Durchgangsloch mit einem geschlossenen Querschnitt ist.

4. Sensor-Einheit nach Anspruch 1 oder 2, wobei die Aussparung (116, 216) in einem peripheren Bereich des Sensor-Substrats angeordnet ist und einen offenen Querschnitt hat.

5. Sensor-Einheit nach einem der vorangehenden Ansprüche, wobei der Schaltungsträger (106, 206) wenigstens eine Anschlussfläche (134, 234) umfasst, die mit der zweiten Kontaktfläche zum Verbinden der Sensor-Einheit (100, 200) mit einer externen Komponente gekoppelt ist.

6. Sensor-Einheit nach einem der vorangehenden Ansprüche, wobei das Wandlerelement (102, 202) einen MEMS-Gassensor und/oder einen MEMS-Drucksensor umfasst.

7. Sensor-Einheit nach einem der vorangehenden Ansprüche, wobei das Sensor-Substrat (104, 204) und/oder der Schaltungsträger (106, 206) einen keramischen Chipträger umfassen/umfasst.

8. Verfahren zum Verbinden eines Substrats und eines Trägers, wobei das Verfahren die folgenden Schritte umfasst:
Bereitstellen wenigstens eines Wandlerelementes (102, 202) zum Überwachen wenigstens einer Messgröße und zum Erzeugen eines elektrischen Ausgangssignals, das mit der wenigstens einen Messgröße korreliert;
Bereitstellen eines Substrats (104, 204), wobei das Substrat (104, 204) eine erste Fläche (108, 208) und eine gegenüberliegende zweite Fläche (110, 210) aufweist, das Substrat das Wandlerelement (102, 202) sowie wenigstens eine erste elektrisch leitende Kontaktfläche (114, 214) umfasst, die an der ersten Fläche (108, 208) des Substrats angeordnet ist, und eine Aussparung (116, 216) in dem Substrat vorhanden ist, wobei sich die Aussparung von der ersten Fläche zu der zweiten Fläche erstreckt;
Bereitstellen eines Schaltungsträgers (106, 206) zum Anbringen des Substrats (104, 204), wobei der Schaltungsträger (106, 206) wenigstens eine mit der ersten elektrisch leitenden Kontaktfläche (114, 214) zu verbindende zweite elektrisch leitende Kontaktfläche (118, 218) aufweist, die zweite elektrisch leitende Kontaktfläche an einer Fläche des Schaltungsträgers (106, 206) angeordnet ist, die so ausgeführt ist, dass sie der ersten Fläche (108, 208) des Substrats zugewandt ist;
Anbringen des Substrats (104, 204) an dem Schaltungsträger, so dass die erste Fläche des Substrats der Fläche des Schaltungsträgers zugewandt ist;
Einfüllen eines elektrisch leitenden Materials von der zweiten Fläche in Richtung der ersten Fläche des Substrats durch die Aussparung (116, 216) hindurch;
Durchführen eines Schrittes zum Aushärten des elektrisch leitenden Materials, so dass eine elektrische Verbindung zwischen der wenigstens einen ersten elektrisch leitenden Kontaktfläche und der entsprechenden wenigstens einen zweiten elektrisch leitenden Kontaktfläche hergestellt wird;
wobei das wenigstens eine Wandlerelement (102, 202) wenigstens teilweise von einem schützenden Material (120, 220) umschlossen wird,
und das schützende Material (120, 220) so eingerichtet ist, dass es einen Spalt (122, 222) zwischen der ersten elektrisch leitenden Kontaktfläche (114, 214) und der zweiten elektrisch leitenden Kontaktfläche (118, 218) bildet.

9. Verfahren nach Anspruch 8, wobei das elektrisch leitende Material mittels Siebdrucken oder Ausgeben einer Lotpaste eingefüllt wird und/oder der Schritt zum Aushärten Erhitzen zum Verflüssigen des elektrisch leitenden Materials umfasst.

10. Verfahren nach einem der Ansprüche 8 bis 9, wobei die Aussparung (116, 216) als metallisiertes röhrenförmiges Durchgangsloch mit einem geschlossenen Querschnitt ausgebildet ist, und/oder die Aussparung in einem peripheren Bereich des Sensor-Substrats angeordnet ist und einen offenen Querschnitt hat.

11. Verfahren nach einem der Ansprüche 8 bis 10, wobei die Schritte des Anbringens und Anlötens des Substrats an dem Schaltungsträger als Platten-Prozesse durchgeführt werden, bei denen eine Vielzahl von Einheiten miteinander verbunden sind, und das Verfahren des Weiteren den Schritt des Trennens der Einheiten umfasst.

12. Verfahren nach Anspruch 11, wobei die Aussparungen (116, 216) als röhrenförmige Durchgangslöcher an Bereichen ausgebildet werden, die Ecken und/oder Kanten der Einheiten bilden, und durch Trennen der Einheiten Aussparungen mit offenen Querschnitten an den Ecken und/oder Kanten der getrennten Einheiten ausgebildet werden.

13. Verfahren nach einem der Ansprüche 8 bis 12, wobei das Substrat ein Sensor-Substrat (104, 204) mit wenigstens einem Wandlerelement (102, 202) ist, das betrieben werden kann, um wenigstens eine Messgröße zu überwachen und wenigstens ein elektrisches Ausgangssignal zu erzeugen, das mit der wenigstens einen Messgröße korreliert.

14. Verfahren nach Anspruch 13, das des Weiteren den Schritt umfasst, in dem das schützende Material (120, 220) so aufgebracht wird, dass es das Wandlerelement wenigstens teilweise umschließt.

## Revendications

1. Unité de capteur comprenant :
au moins un élément transducteur (102, 202) destiné à surveiller au moins une grandeur et à générer le signal de sortie électrique corrélée avec la ou les grandeurs mesurées,
un substrat de capteur (104, 204) comportant une première surface (108, 208) et une seconde surface (110, 210) opposée, ledit substrat de capteur (104, 204) comprenant ledit élément transducteur (102, 202) et au moins un premier plot de contact (114, 214) électriquement conducteur disposé sur la première surface (108, 208) du substrat de capteur (104, 204), ledit premier plot de contact électriquement conducteur étant relié électriquement à l'élément transducteur,
où un évidement (116, 216) est ménagé dans le substrat de capteur (104, 204), l'évidement (116, 216) s'étendant depuis la seconde surface (110, 210) jusqu'à la première surface (108, 208), l'évidement étant disposé pour permettre un remplissage par un matériau électriquement conducteur (124, 224, 126, 226),
où ledit substrat de capteur (104, 204) est monté sur un support de circuit (106, 206) de sorte à ce que la première surface (108, 208) fasse face à une surface du support de circuit (106, 206),
où le support de circuit (106, 206) comprend au moins un second plot électriquement conducteur (118, 218) disposé sur la surface du support de circuit, le premier plot de contact électriquement conducteur (114, 214) et le second plot de contact électriquement conducteur (118, 218) étant interconnectés par le matériau électriquement conducteur (124, 224 ; 126 ; 226),
où le ou les éléments transducteurs (102, 202) sont au moins partiellement englobés par un matériau protecteur (120, 220), le matériau protecteur étant disposé pour former un intervalle (122, 222) entre le premier plot de contact électriquement conducteur (114, 214) et le second plot de contact électriquement conducteur (118, 218).

2. Unité de capteur selon la revendication 1, dans laquelle ledit matériau électriquement conducteur est un matériau de soudure (124, 224 ; 126 ; 226), une colle électriquement conductrice ou une résine époxy remplie de métal.

3. Unité de capteur selon la revendication 1 ou la revendication 2, dans laquelle ledit évidement (116, 216) est une traversée en forme de tube présentant une section transversale fermée.

4. Unité de capteur selon la revendication 1 ou la revendication 2, dans laquelle ledit évidement (116, 216) est disposée dans une zone périphérique du substrat de capteur et présente une section transversale ouverte.

5. Unité de capteur selon l'une des revendications précédentes, dans laquelle le support de circuit (106, 206) comprend au moins un plot de connexion (134, 234) qui est interconnecté sur ledit second plot de contact afin de relier l'unité de capteur (100, 200) à un composant extérieur.

6. Unité de capteur selon l'une des revendications précédentes, dans lequel ledit élément transducteur (102, 202) comprend un capteur de gaz à système micro électromécanique (MEMS) et/ou un capteur de pression à système MEMS.

7. Unité de capteur selon l'une des revendications précédentes, dans lequel ledit substrat de capteur (104, 204) et/ou le substrat de capteur (104, 204) comprennent un support de puces céramique.

8. Procédé d'interconnexion d'un substrat et d'un support, ledit procédé comprenant les étapes suivantes :
l'utilisation d'au moins un élément transducteur (102, 202) destiné à surveiller au moins une grandeur et à générer un signal de sortie électrique corrélé avec la ou les grandeurs mesurées,
l'utilisation d'un substrat (104, 204), le substrat (34, 204) comportant une première surface (108, 208) et une seconde surface (110, 210) opposée, ledit substrat comprenant ledit élément transducteur (102, 202) et au moins un premier plot de contact électriquement conducteur (114, 214) disposé sur la première surface (108, 208), un évidement (116, 216) étant ménagé dans le substrat, l'évidement s'étendant depuis la première surface jusqu'à la seconde surface,
l'utilisation d'un support de circuit (106, 206) pour monter ledit substrat (104, 204), le support de circuit (106, 206) possédant au moins un second plot de contact électriquement conducteur (118, 218) à relier au premier plot de contact électriquement conducteur (114, 214), le second plot électriquement conducteur étant disposé sur une surface du support de circuit (106, 206) configurée pour faire face à la première surface (108, 208) du substrat,
le montage du substrat (104, 204) sur le support de circuit de sorte à ce que la première surface du substrat fasse face à la surface du support de circuit,
au travers dudit évidement (116, 216), le remplissage avec un matériau électriquement conducteur à partir de la seconde surface en direction de la première surface du substrat,
la réalisation d'une étape de polymérisation du matériau électriquement conducteur de sorte à ce qu'une connexion électrique soit formée entre le ou les premiers plots de contact électriquement conducteurs et le ou les seconds plots correspondants électriquement conducteurs,
dans lequel le ou les éléments transducteurs (102, 202) sont au moins partiellement englobés par un matériau protecteur (120, 220),
le matériau protecteur (120, 220) est agencé pour former un intervalle (122, 222) entre le premier plot de contact électriquement conducteur (114, 214) et le second plot de contact électriquement conducteur (118, 218).

9. Procédé selon la revendication 8, dans lequel ledit matériau électriquement conducteur est délivré au moyen d'une impression par sérigraphie ou de la délivrance d'une patte de soudure et/ou dans lequel l'étape de polymérisation comprend un chauffage de sorte à ce que le matériau électriquement conducteur soit liquéfié.

10. Procédé selon l'une des revendications 8 à 9, dans lequel ledit évidement (116, 216) est façonné comme un trou traversant en forme de tube possédant une section transversale fermée, et/ou dans lequel ledit évidement est disposé dans une zone périphérique du substrat de capteur et possède une section transversale ouverte.

11. Procédé selon l'une des revendications 8 à 10, dans lequel les étapes de montage et de soudure du substrat sur le support de circuit sont effectuées sous forme de processus de panneaux, une pluralité d'unités étant associées l'une à l'autre, le procédé comprenant en outre l'étape de séparation des unités.

12. Procédé selon la revendication 11, dans lequel les évidements (116, 216) sont formés sous forme de trous traversants en forme de tubes au niveau de zones qui forment des coins et/ou des bords des unités, et où, en séparant les unités, les évidements présentant des sections transversales ouvertes sont formées au niveau des coins et/ou des bords des unités séparées.

13. Procédé selon l'une des revendications 8 à 12, dans lequel le substrat est un substrat de capteur (104, 204) comportant au moins un élément transducteur 102, 202) qui peut être mis en œuvre pour surveiller au moins une grandeur et pour générer un signal de sortie électrique corrélé avec la ou les grandeurs mesurées.

14. Procédé selon la revendication 13, comprenant en outre l'étape de fixation du matériau protecteur (120, 220) de sorte à ce qu'il englobe au moins partiellement l'élément transducteur.
